# FASCICULE DE BREVET EUROPEEN

(11) **EP 0 531 757 B1**
(45) Date de publication et mention de la délivrance du brevet: **12.04.1995**
(21) Numéro de dépôt: 92114066.1
(22) Date de dépôt: 18.08.1992
(51) Int. Cl.: H03L 7/107, H03L 7/16

(54) **Procédé de commande d'un synthétiseur de fréquence pourvu d'une entrée de modulation**
Verfahren zur Steuerung eines mit einem Modulationseingang versehenen Frequenzsynthetisierers
Method for controlling a frequency synthesizer provided with a modulation input

(30) Priorité: 23.08.1991 FR 9110572
(43) Date de publication de la demande: 17.03.1993
(73) Titulaire: ALCATEL MOBILE COMMUNICATION FRANCE, 75008 Paris (FR)
(72) Inventeur: Le Barillec, Roger, F-53000 Laval (FR); Bouisse, Gérard, F-53000 Laval (FR)
(74) Mandataire: Weinmiller, Jürgen

(56) Documents cités:
- DE-A- 3 939 709
- US-A- 4 516 083
- US-A- 4 748 425
- US-A- 4 928 075

## Description

La présente invention concerne un procédé de commande d'un synthétiseur de fréquence pourvu d'une entrée de modulation.

Lorsqu'il s'agit de transmettre une information, on procède couramment à la modulation d'une onde porteuse par un signal de modulation qui représente cette information. A cet effet, on emploie généralement un synthétiseur de fréquence pourvu d'une entrée de modulation. Un tel synthétiseur comprend un oscillateur commandé en tension qui reçoit comme signal de commande une combinaison d'un signal d'asservissement et du signal de modulation, cette combinaison pouvant se réduire, par exemple, à une addition. Le signal de sortie de l'oscillateur qui est également le signal de sortie du synthétiseur est appliqué à une boucle à verrouillage de phase qui compare la fréquence de ce signal à un signal de référence pour produire un signal d'écart. Ce signal d'écart est ensuite injecté sur un filtre passe-bas qui produit le signal d'asservissement. Il faut en effet supprimer l'influence du signal de modulation dans l'élaboration de la fréquence de l'onde porteuse. Il s'ensuit que la fréquence de coupure du filtre passe-bas doit être nettement inférieure à la fréquence la plus basse du signal de modulation.

Par ailleurs, la fréquence de coupure du filtre passe-bas détermine directement le temps de verrouillage du synthétiseur, c'est-à-dire le temps qui s'écoule entre l'application du signal de référence et la concordance du signal de sortie avec cette référence.

Il n'est pas souhaitable que ce temps de verrouillage soit trop important car le synthétiseur ne peut pas être utilisé de manière satisfaisante avant que ce temps ne soit écoulé.

La demande de brevet allemande n°3.939.709 au nom de la société Robert Bosch GmbH décrit un synthétiseur de fréquence pourvu d'une entrée de modulation et comprenant un oscillateur commandé en tension suivi d'une boucle à verrouillage de phase elle-même suivie d'un jeu de filtres passe-bas commutables individuellement qui délivre un signal d'asservissement, l'oscillateur recevant comme signal de commande une combinaison du signal d'asservissement et d'un signal de modulation appliqué sur l'entrée de modulation. Des moyens sont prévus pour substituer un filtre à un autre afin d'augmenter la vitesse de réponse de l'oscillateur lors d'un changement de canal de fréquence. Ce document propose d'utiliser un filtre unique si le signal de modulation est un signal de parole et ne peut donc permettre de diminuer le temps de verrouillage de l'oscillateur si le signal de modulation est modifié.

Le brevet américain n°4.516.083 décrit un procédé de commande d'un synthétiseur de fréquence pourvu d'une entrée de modulation et comprenant un oscillateur commandé en tension suivi d'une boucle à verrouillage de phase elle-même suivie d'un jeu de filtres passe-bas pour délivrer un signal d'asservissement. L'oscillateur reçoit comme signal de commande une combinaison du signal d'asservissement et d'un signal de modulation appartenant à un mode spécifié parmi plusieurs modes possibles, le signal de modulation étant appliqué sur l'entrée de modulation. Le procédé de commande du synthétiseur consiste à sélectionner un des filtres en réponse à un signal de sélection produit par un module de sélection à partir d'un signal d'identification identifiant lequel des filtres doit être introduit entre la boucle à verrouillage de phase et l'oscillateur.

Selon la présente invention, le procédé consiste à produire le signal de sélection en fonction du mode auquel appartient le signal de modulation, la fréquence de coupure du filtre passe-bas ainsi sélectionné étant très inférieure à la fréquence minimale du signal de modulation appartenant au mode spécifié.

Il est ainsi possible d'adapter le filtre à la nature du signal de modulation, ce qui permet d'obtenir un temps de verrouillage réduit lorsque ce signal le permet.

Avantageusement, au moins un des filtres comprend des moyens pour augmenter sa fréquence de coupure en réponse à un signal de validation.

Ainsi, lorsqu'aucun signal de modulation n'est appliqué, on peut diminuer encore plus le temps de verrouillage.

Le synthétiseur selon l'invention trouvera notamment application dans un émetteur-récepteur de radiotéléphone.

La présente invention apparaîtra plus clairement à la lecture de la description suivante d'un exemple de réalisation préférentiel, donné à titre illustratif et non limitatif, et des figures annexées qui représentent :
- la figure 1 : un synthétiseur connu ;
- la figure 2 : un mode de réalisation préférentiel du synthétiseur de l'invention.

Les éléments identiques dans les deux figures seront affectés d'une seule référence.

En premier lieu, on rappellera la constitution d'un synthétiseur connu.

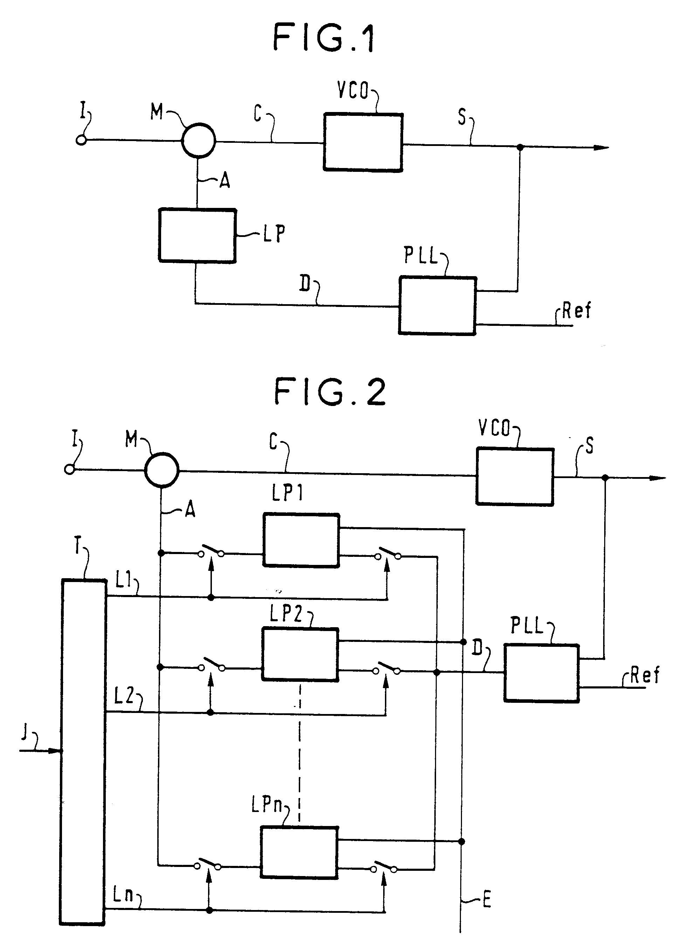

En référence à la figure 1, le synthétiseur comprend un oscillateur commandé en tension VCO qui produit un signal de sortie S. Il comprend également une boucle à verrouillage de phase PLL qui reçoit ce signal de sortie et un signal de référence Ref pour produire un signal d'écart D. Ce signal d'écart est appliqué sur un filtre passe-bas LP qui produit un signal d'asservissement A. Le signal de commande C de l'oscillateur résulte de la somme du signal d'asservissement A et du signal de modulation appliqué sur l'entrée de modulation I, somme effectuée dans un circuit de combinaison M.

Le signal de référence peut être délivré, par exemple, par un oscillateur à quartz éventuellement stabilisé en température.

Un synthétiseur de ce type sera avantageusement utilisé dans le domaine de la radiotéléphonie où la fréquence de modulation dépend des modes de modulation utilisés suivants :
- mode phonie : fréquence variant de 300 à 3000 Hz,
- mode signalisation infra-bande : fréquence variant de 67 à 250 Hz,
- mode signalisation appel sélectif de type FFSK : fréquence valant 1200 ou 1800 Hz,
- mode signalisation appel sélectif séquentiel : fréquence variant de 980 à 2800 Hz,
- mode transmission de données : fréquence de quelques Hz à quelques kHz.

Comme cela a été mentionné dans l'introduction, la fréquence de coupure du filtre passe-bas LP doit être très inférieure à la fréquence de modulation minimale qui doit être transmise.

Ainsi, pour un synthétiseur devant fonctionner en mode phonie et en mode signalisation infra-bande, une fréquence de coupure de l'ordre de 25 Hz donne d'excellents résultats.

Cependant, le temps de verrouillage s'élève à quelques dizaines de millisecondes.

Au contraire, si le synthétiseur doit fonctionner selon le mode transmission de données à 1200 bits/s, une fréquence de coupure de 300 Hz suffit et le temps de verrouillage se trouve réduit à quelques millisecondes.

Le synthétiseur connu présente donc un temps de verrouillage fixe qui est lié à la fréquence de modulation minimale employée.

L'invention propose des moyens pour optimiser ce temps de verrouillage, moyens qui seront maintenant décrits.

La solution à ce problème consiste à utiliser plusieurs filtres de boucles adaptées chacun à un mode de modulation qui sont commutés en fonction du mode utilisé.

Par ailleurs, lors du chargement du synthétiseur, c'est-à-dire lorsque l'ordre lui est donné de s'asservir sur le signal de référence, aucun signal de modulation n'est appliqué. Le temps de verrouillage peut donc être fixé à une valeur très faible.

En référence à la figure 2, le synthétiseur comprend comme précédemment un oscillateur VCO, une boucle à verrouillage de phase PLL et un circuit de combinaison M. Cependant, il n'y a pas ici un seul mais plusieurs filtres passe-bas LP1, LP2,...,LPn. Chacun de ces filtres reçoit le signal d'écart D par l'intermédiaire d'un premier commutateur et le transmet au circuit de combinaison M par l'intermédiaire d'un deuxième commutateur. On définit ainsi des moyens de commutation associés à ces filtres. Les deux commutateurs du premier filtre LP1 sont commandés par un premier signal de sélection L1, les deux commutateurs du second filtre LP2 sont commandés par un deuxième signal de sélection L2 et ainsi de suite. Lorsque le premier signal de sélection L1 est actif, tous les autres L2,...,Ln sont inactifs et c'est alors le premier filtre LP1 qui produit le signal d'asservissement A à partir du signal d'écart D. De manière plus générale, lorsque l'un quelconque des signaux de sélection est actif, tous les autres sont inactifs : les commutateurs du filtre passe-bas associés au signal de sélection actif sont fermés, tandis les commutateurs des filtres passe-bas associés aux signaux de sélection inactifs sont ouverts.

Les signaux de sélection sont produits par un module de sélection T à partir d'un signal d'identification J. Dans le cas présent, un signal d'identification précise par exemple le mode de modulation. S'il s'agit du mode phonie, c'est le filtre LP1 qui doit être sélectionné et c'est donc le premier signal de sélection L1 qui est activé. S'il s'agit du mode transmission de données c'est le deuxième filtre LP2 qui doit être sélectionné et c'est donc le deuxième signal de sélection qui est activé. La généralisation du fonctionnement du module de sélection se fait sans peine. Ce module a pour but de sélectionner le filtre qui convient pour un signal de modulation donné, ceci au moyen du signal d'identification qui précise la nature de ce signal de modulation.

On prévoit de plus que lors du chargement de synthétiseur, la fréquence de coupure du filtre passe-bas sélectionné peut être très élevée. A cet effet un signal de validation E est produit simultanément à destination de tous les filtres de manière à ce que ceux-ci présentent une fréquence de coupure beaucoup plus haute. Un moyen simple pour augmenter cette fréquence de coupure consiste à court-circuiter le filtre.

## Revendications

1. Procédé de commande d'un synthétiseur de fréquence pourvu d'une entrée de modulation (I) et comprenant un oscillateur commandé en tension (VCO) suivi d'une boucle à verrouillage de phase (PLL) elle-même suivie d'un jeu de filtres passe-bas (LPl, ..., LPn) pour délivrer un signal d'asservissement (A), ledit oscillateur recevant comme signal de commande une combinaison dudit signal d'asservissement (A) et d'un signal de modulation appartenant à un mode spécifié parmi plusieurs modes possibles, ledit signal de modulation étant appliqué sur ladite entrée de modulation (I), ledit procédé consistant à sélectionner un desdits filtres (LP1, ..., LPn) en réponse à un signal de sélection produit par un module de sélection (T) à partir d'un signal d'identification (J) identifiant lequel desdits filtres (LP1,..., LPn) doit être introduit entre ladite boucle à verrouillage de phase (PLL) et ledit oscillateur (VCO),
caractérisé en ce qu'il consiste à produire ledit signal de sélection en fonction du mode auquel appartient ledit signal de modulation, la fréquence de coupure du filtre passe-bas (LP1, ..., LPn) ainsi sélectionné étant très inférieure à la fréquence minimale du signal de modulation appartenant au mode spécifié.

2. Procédé selon la revendication 1, caractérisé en ce qu'il consiste également à augmenter la fréquence de coupure d'au moins un desdits filtres (LP1,..., LPn) en réponse à un signal de validation (E).

3. Procédé selon l'une des revendications 1 et 2, caractérisé en ce qu'il est appliqué à un émetteur-récepteur de radiotéléphone.

## Patentansprüche

1. Verfahren zur Steuerung eines Frequenzsynthetisierers, der eine Modulationseingang (I) und einen spannungsgesteuerten Oszillator (VCO), gefolgt von einer Phasenverriegelungsschleife (PLL) besitzt, der ihrerseits ein Satz von Tiefpaßfiltern (LP1, ... LPn) nachgeschaltet ist, um ein Regelsignal (A) zu liefern, wobei der Oszillator als Steuersignal eine Kombination des Regelsignals (A) und eines Modulationssignals zugeführt erhält, das einem bestimmten Typus von mehreren möglichen Typen angehört und das an den Modulationseingang (I) angelegt wird, wobei das Verfahren darin besteht, eines der Filter (LP1, ... LPn) abhängig von einem Selektionssignal auszuwählen, das von einem Selektionsmodul (T) abhängig von einem Identifikationssignal (J) erzeugt wird, welches eines der Filter (LP1, ... LPn) identifiziert, das zwischen die Phasenverriegelungsschleife (PLL) und den Oszillator (VCO) eingefügt werden soll,
dadurch gekennzeichnet, daß das Verfahren darin besteht, das Selektionssignal abhängig von dem Typus zu erzeugen, dem das Modulationssignal angehört, wobei die Grenzfrequenz des so ausgewählten Tiefpaßfilters (LP1, ... LPn) deutlich unterhalb der niedrigsten Frequenz des Modulationssignals ist, das bei dem spezifizierten Typus auftritt.

2. Verfahren nach Anspruch 1, dadurch gekennzeichnet, daß es weiter darin besteht, die Grenzfrequenz mindestens eines der Filter (LP1, ... LPn) abhängig von einem Validierungssignal (E) zu erhöhen.

3. Verfahren nach einem der Ansprüche 1 und 2, dadurch gekennzeichnet, daß es auf einen Sender-Empfänger in Mobiltelefonsystemen angewendet wird.

## Claims

1. Method of controlling a frequency synthesiser having a modulation input (I) and comprising a voltage-controlled oscillator (VCO) followed by a phase-locked loop (PLL) in turn followed by a set of low-pass filters (LP1, ..., LPn) to deliver a control signal (A), said oscillator receiving by way of control signal a combination of said control signal (A) and a modulation signal for a specified mode which is one of a plurality of possible modes, said modulation signal being applied to said modulation input (I), said method consisting in selecting one of said filters (LP1, ..., LPn) in response to a selection signal produced by a selection module (T) from an identification signal (J) identifying which of said filters (LP1, ..., LPn) must be inserted between said phase-locked loop (PLL) and said oscillator (VCO),
characterised in that it consists in producing said selection signal according to the mode respective to said modulation signal, the cut-off frequency of the low-pass filter (LP1, ..., LPn) selected in this way being very much lower than the minimal frequency of the modulation signal for the specified mode.

2. Method according to claim 1 characterised in that it also consists in increasing the cut-off frequency of at least one of said filters (LP1, ..., LPn) in response to an enabling signal (E).

3. Method according to claim 1 or claim 2 characterised in that it is applied to a mobile telephone transceiver.
